# EUROPEAN PATENT SPECIFICATION

(11) **EP 3 062 360 B1**
(45) Date of publication and mention of the grant of the patent: **24.02.2021**
(21) Application number: 14855038.7
(22) Date of filing: 14.10.2014
(51) Int. Cl.: H01L 51/30, H01B 1/22, H01B 5/14, H01L 21/288, H01L 29/786

(54) **CONDUCTIVE FILM FORMING COMPOSITION, CONDUCTIVE FILM, ORGANIC THIN FILM TRANSISTOR, ELECTRONIC PAPER, DISPLAY DEVICE, AND WIRING BOARD**
LEITFÄHIGE FILMBILDENDE ZUSAMMENSETZUNG, LEITFÄHIGER FILM, ORGANISCHER DÜNNSCHICHTTRANSISTOR, ELEKTRONISCHES PAPIER, ANZEIGEVORRICHTUNG UND LEITERPLATTE
COMPOSITION DE FORMATION DE FILM CONDUCTEUR, FILM CONDUCTEUR, TRANSISTOR EN COUCHES MINCES ORGANIQUE, PAPIER ÉLECTRONIQUE, DISPOSITIF D'AFFICHAGE ET CARTE DE CÂBLAGE

(30) Priority: 24.10.2013 JP 2013221251; 27.12.2013 JP 2013271971; 31.01.2014 JP 2014017288
(43) Date of publication of application: 31.08.2016
(73) Proprietor: FUJIFILM Corporation, Tokyo 106-8620 (JP)
(72) Inventor: MATSUSHITA Yasuaki, Ashigara-kami-gun Kanagawa 258-8577 (JP); MATSUMURA Tokihiko, Ashigara-kami-gun Kanagawa 258-8577 (JP)
(74) Representative: Hoffmann Eitle
(86) International application number: PCT/JP2014/077327
(87) International publication number: WO 2015/060160

(56) References cited:
- WO-A1-2009/087793
- WO-A1-2013/141278
- JP-A- 2006 335 995
- JP-A- 2007 070 370
- JP-A- 2008 274 096
- JP-A- 2008 535 964
- JP-A- 2009 120 631
- JP-A- 2013 532 195
- US-A1- 2013 059 135

## Description

### BACKGROUND OF THE INVENTION

### 1. Field of the Invention

The present invention relates to a conductive film forming composition and to a conductive film, an organic thin film transistor, electronic paper, a display device, and a wiring board which use the conductive film forming composition.

### 2. Description of the Related Art

An organic thin film transistor (organic TFT) is used in a field effect transistor (FET) used in a liquid crystal display or an organic EL display, an apparatus using a logic circuit such as an RF tag (RFID) or a memory, and the like, because the use of the organic thin film transistor makes it possible to reduce the weight of the aforementioned apparatuses, to reduce the costs, and to make the apparatuses flexible.

Generally, the organic thin film transistor includes a substrate, a gate insulating film, an organic semiconductor layer, and 3 electrodes (a gate electrode, a source electrode, and a drain electrode).

As a method for forming a conductive film such as an electrode or wiring on a substrate, an insulating film, or the like, a method is known in which the conductive film is formed by coating the substrate or the insulating film with a metal particle (for example, silver particle) dispersion and sintering the dispersion. Compared to the conductive film forming method of the related art that is performed by high heat/vacuum processing (sputtering) or a plating treatment, the aforementioned method is performed in a simpler way and saves more energy and resources. Therefore, there are great expectations for the method in regard to the development of next-generation electronics.

For example, JP2008-274096A discloses a conductive ink composition containing metal particles and a triarylsulfonium salt, and describes that the composition can be used for the formation of wiring of a circuit board and the like (claim 1, paragraphs "0015" and "0046", and the like).

WO 2013/141278 A1 discloses an ink comprising silver nano-wires and dimethyl-dodecyl ammonium sulfonate, for use in the formation of conductors. Similarly, US 2013/059135 A1 discloses an ink comprising Au particles and 1-butyl-1-methyl pyrrolidinium bis(trifluoromethyl sulfonyl)imide.

### SUMMARY OF THE INVENTION

In recent years, as the organic thin film transistor has been increasingly miniaturized, and the performance thereof has been improved, excellent mobility (particularly, field effect mobility) and stability (for example, insulation reliability) have been required for the organic thin film transistor.

Under these circumstances, with reference to JP2008-274096A, the inventors of the present invention prepared an organic thin film transistor by forming electrodes using the composition containing metal particles and a triarylsulfonium salt. As a result, it has become evident that the mobility of the obtained organic thin film transistor does not satisfy the currently required level. Furthermore, as a result of testing the service life of the obtained organic thin film transistor, electrochemical migration of conductive substances markedly occurred between a source electrode and a drain electrode, and accordingly, it has become evident that the insulation reliability of the obtained organic thin film transistor does not satisfy the currently required level.

The present invention has been made in consideration of the aforementioned circumstances, and objects thereof are to provide a conductive film forming composition which makes it possible to obtain an organic thin film transistor having excellent insulation reliability and high mobility and to provide a conductive film, an organic thin film transistor, electronic paper, a display device, and a wiring board which use the conductive film forming composition.

In order to achieve the aforementioned objects, the inventors of the present invention conducted intensive investigation. As a result, the inventors obtained knowledge that by forming electrodes using a conductive film forming composition containing metal particles and a specific salt, an organic thin film transistor which exhibits excellent insulation reliability and high mobility is obtained. Based on the knowledge, the inventors accomplished the present invention. That is, the inventors found that the aforementioned objects can be achieved by the following constitution.

(1) A conductive film forming composition containing metal particles (A) and a compound (B) represented by Formula (I) which will be described later.
(2) The conductive film forming composition described in (1), in which the metal particles (A) are particles of a metal selected from the group consisting of Ag, Cu, Al, Ni, and Ta.
(3) The conductive film forming composition described in (1) or (2), in which in Formula (I) which will be described later, A^{m-} is an anion selected from the group consisting of SO₄²⁻, R_{A2}SO₄⁻, R_{A3}SO₃⁻ , PO₄³⁻, R_{A4}PO₄²⁻ , (R_{A5})₂PO₄⁻, PO₃³⁻, R_{A6}PO₃²⁻, (R_{A7})₂PO₃⁻, [BF₄]⁻, [B(CN)₄]⁻, [B(C₆H₅)₄]⁻, CN⁻, OCN⁻, SCN⁻, [R_{A8}-COO]⁻, [(R_{A9}-SO₂)₂N]⁻, N(CN)₂⁻, and (R_{A11})₂NCS₂⁻ (herein, each of R_{A2} to R_{A9} and R_{A11} independently represents a hydrogen atom or a hydrocarbon group which may have a substituent).
(4) The conductive film forming composition described in any one of (1) to (3), in which in Formula (I) which will be described later, Cⁿ⁺ is a cation selected from the group consisting of Formulae (A) to (C).
(5) The conductive film forming composition described in any one of (1) to (4), in which in Formula (1) which will be described later, A^{m-} is an anion selected from the group consisting of SO₄²⁻, R_{A2}SO₄⁻, and R_{A3}SO₃⁻ (herein, each of R_{A2} and R_{A3} independently represents a hydrogen atom or a hydrocarbon group which may have a substituent).
(6) A conductive film formed using the conductive film forming composition described in any one of (1) to (5).
(7) An organic thin film transistor including electrodes formed using the conductive film forming composition described in any one of (1) to (5).
(8) Electronic paper using the organic thin film transistor described in (7).
(9) A display device using the organic thin film transistor described in (7).
(10) A wiring board including wiring formed using the conductive film forming composition described in any one of (1) to (5).

As will be described below, according to the present invention, it is possible to provide a conductive film forming composition which makes it possible to obtain an organic thin film transistor exhibiting excellent insulation reliability and high mobility and to provide a conductive film, an organic thin film transistor, electronic paper, a display device, and a wiring board which use the conductive film forming composition.

### BRIEF DESCRIPTION OF THE DRAWINGS

Fig. 1 is a schematic sectional view of an aspect of an organic thin film transistor of the present invention.
Fig. 2 is a schematic sectional view of another aspect of the organic thin film transistor of the present invention.

### DESCRIPTION OF THE PREFERRED EMBODIMENTS

Hereinafter, a conductive film forming composition of the present invention and the organic thin film transistor and the like using the conductive film forming composition will be described.

In the present specification, a range of numerical values represented using "to" means a range including the numerical values listed before and after "to" as a lower limit and an upper limit respectively.

### [Conductive film forming composition]

The conductive film forming composition of the present invention (hereinafter, referred to as a composition of the present invention as well) contains metal particles (A) and a compound (B) represented by Formula (I) which will be described later.

It is considered that intended effects are obtained because the composition of the present invention is constituted as above.

The reason is unclear but is assumed to be as below.

When voltage is applied to an electrode of an organic thin film transistor, due to the action of an electric field, a conductive substance such as a metal in the electrode is ionized, and this leads to the movement (migration) of ions in an organic semiconductor layer in some cases. If the migration occurs, the insulating properties between source/drain electrodes deteriorate. That is, the insulation reliability deteriorates.

In a case where an electrode (conductive film) is formed using the composition of the present invention, the electrode contains a conductive substance such as a metal and the compound (B) constituted with specific cation and anion. Consequently, even if the conductive substance such as a metal in the electrode is ionized as described above, the substance is trapped in the compound (B) in the electrode, and hence the migration is prevented. That is, the compound (B) functions as an excellent migration inhibitor (anti-migration agent). It is considered that, as a result, the organic thin film transistor having an electrode formed using the composition of the present invention exhibits excellent insulation reliability. The mechanism described above is considered to result from a fact that the specific anion contained in the compound (B) exhibits extremely high affinity with ions of the conductive substance such as a metal.

Because of being highly stable in the electrode, and hence the compound (B) does not easily dissociate and move to the adjacent organic semiconductor layer or the like. It is considered that, as a result, the compound (B) substantially does not exert a negative influence on the mobility of the organic thin film transistor, and thus the organic thin film transistor exhibits high mobility. The mechanism described above is considered to particularly result from a fact that the compound (B) has properties in which the specific cation or anion contained in the compound (B) does not easily dissociate even in a state where the ions are trapped in the compound (B).

Hereinafter, each component contained in the composition of the present invention will be specifically escribed.

### <Metal particles (A)>

The metal particles (A) contained in the composition of the present invention are not particularly limited as long as they have a particle shape.

The particle shape refers to the shape of a small particle, and examples thereof include a spherical shape, an elliptical shape, and the like. The particle does not need to be a perfect sphere or ellipse and may be partially distorted.

The metal particles (A) are preferably particles of a metal selected from the group consisting of silver (Ag), copper (Cu), aluminum (Al), nickel (Ni), and tantalum (Ta), more preferably silver particles or copper particles, and even more preferably silver particles.

The metal particles (A) are preferably conductive nanoparticles.

In a case where the metal particles (A) are silver nanoparticles, the method for preparing the particles is not particularly limited. However, for example, the particles can be prepared by a method in which an aqueous solution of a reductant such as N,N-diethylhydroxylamine is added dropwise to an aqueous solution of a silver salt such as silver nitrate in the presence of a dispersing agent such that the silver salt is reduced by the reductant.

The average particle size of the metal particles (A) is not particularly limited. However, it is preferably equal to or less than 200 nm, and more preferably equal to or less than 100 nm. The lower limit of the average particle size is not particularly limited but is preferably equal to or greater than 5 nm.

In the present invention, the average particle size means an average particle size measured using a concentrated system particle size analyzer FPAR-1000 (manufactured by OTSUKA ELECTRONICS Co., LTD).

The content of the metal particles (A) in the composition of the present invention is not particularly limited. However, the content of the metal particles (A) is preferably 5.0% by mass to 80.0% by mass, and more preferably 10.0% by mass to 60.0% by mass, with respect to the total amount of the composition.

### <Compound (B)>

The composition of the present invention contains the compound (B) represented by the following Formula (I).

cCⁿ⁺aA^{m-} Formula (I)

### (Cation)

In Formula (I), Cⁿ⁺ represents an n-valent cation. Herein, n represents an integer of 1 to 6. That is, Cⁿ⁺ is a cation having a valency of 1 to 6.

In a case where n in Formula (I) is 1 (that is, in a case where Cⁿ⁺ is a monovalent cation), Cⁿ⁺ represents a cation selected from the group consisting of the following Formulae (A) to (E). Among these, Cⁿ⁺ is preferably a cation selected from the group consisting of Formulae (A) to (C). Cⁿ⁺ is more preferably a cation represented by Formula (A) or (B) because then the obtained organic thin film transistor exhibits better insulation reliability.

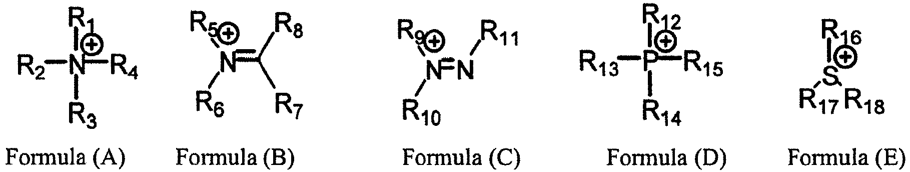

In Formula (A), each of R₁ to R₄ independently represents a hydrogen atom or a hydrocarbon group (excluding a hydroxyalkyl group) which may have a substituent, provided that at least one of R₁ to R₄ is an aromatic hydrocarbon group.

Here, there is no case where all of R₁ to R₄ represent a hydrogen atom at the same time.

The hydrocarbon group is not particularly limited, and examples thereof include a aliphatic hydrocarbon group, an aromatic hydrocarbon group, a group obtained by combining these, and the like.

The aliphatic hydrocarbon group may be linear, branched, or cyclic. The number of carbon atoms of the aliphatic hydrocarbon group is not particularly limited, but is preferably 1 to 12. Specific examples of the aliphatic hydrocarbon group include an alkyl group, an alkenyl group, an alkynyl group, and the like.

The number of carbon atoms of the aromatic hydrocarbon group is not particularly limited, but is preferably 6 to 18. Specific examples of the aromatic hydrocarbon group include an aryl group (a phenyl group, a tolyl group, a xylyl group, or the like), a naphthyl group, and the like.

Examples of the aforementioned substituent include a substituent Q, which will be described later, and the like.

The substituent is preferably a substituent other than a hydroxy group because then the obtained organic thin film transistor exhibits higher mobility.

At least one of R₁ to R₄ is an aromatic hydrocarbon group because then the obtained organic thin film transistor exhibits higher mobility.

As described above, none of R₁ to R₄ in Formula (A) is a hydroxyalkyl group. The hydroxyalkyl group is an alkyl group having a hydroxy group, and examples thereof include a hydroxyethyl group (-C₂H₄-OH) and the like.

In a case where any of R₁ to R₄ is a hydroxyalkyl group, carriers moving between electrodes are trapped, and as a result, the mobility of the obtained organic thin film transistor deteriorates.

Furthermore, as described above, there is no case where all of R₁ to R₄ in Formula (A) represent a hydrogen atom at the same time. That is, Cⁿ⁺ is not NH₄⁺. In a case where Cⁿ⁺ is NH₄⁺, dissociated ammonia easily volatilizes. Accordingly, thermal stability decreases, and the compound (B) is easily decomposed at the time when a conductive film (electrode) is formed by sintering or the like. As a result, the insulation reliability of the obtained organic thin film transistor deteriorates.

In Formula (A), each of R₁ to R₄ may form a cyclic structure by being bonded to each other. That is, two or more groups selected from the group consisting of R₁ to R₄ may form a cyclic structure by being bonded to each other. In the present specification, forming a cyclic structure by being bonded to each other means that two or more groups form a cyclic structure by being bonded to each other at any position through a single bond, a double bond, or a triple bond or through a divalent linking group.

The divalent linking group is not particularly limited, and examples thereof include -CO-, -NH- -NR- (R: substituent (for example, a substituent Q which will be described later)), -O-, -S-, a group obtained by combining these, and the like.

Preferred aspects of the cation represented by Formula (A) will be shown below. Herein, each Rₚ independently represents the group represented by R₁ to R₄ described above. A plurality of Rₚ's may be the same as or different from each other. Each R independently represents a hydrogen atom or a substituent (for example, a substituent Q which will be described later).

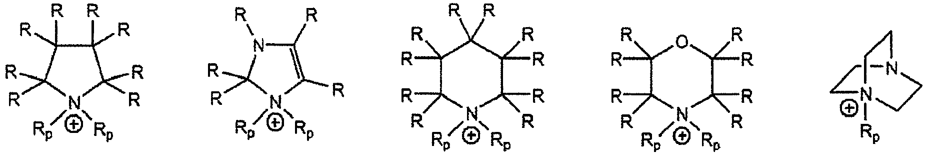

In Formula (B), R5 represents a hydrocarbon group which may have a substituent, -NR₁₉R₂₀, -N=CR₂₁R₂₂, -CR₂₃=NR₂₄, or -CR_{B1}R_{B2}-NR_{B3}R_{B4}. Specific examples and preferred aspects of the hydrocarbon group which may have a substituent are the same as those of R₁ to R₄ in Formula (A) described above.

Each of R₁₉ to R₂₄ and R_{B1} to R_{B4} independently represents a hydrogen atom or a hydrocarbon group which may have a substituent. Specific examples and preferred aspects of the hydrocarbon group which may have a substituent are the same as those of R₁ to R₄ in Formula (A) described above. R₁₉ and R₂₀ may form a cyclic structure by being bonded to each other.

In Formula (B), R₆ represents a hydrogen atom or a hydrocarbon group which may have a substituent. Specific examples and preferred aspects of the hydrocarbon group which may have a substituent are the same as those of R₁ to R₄ in Formula (A) described above.

In Formula (B), R₇ represents a hydrogen atom, a hydrocarbon group which may have a substituent, an alkoxy group, an alkylthio group, a hydroxy group, a mercapto group, or -NR₂₅R₂₆. Specific examples and preferred aspects of the hydrocarbon group which may have a substituent are the same as those of R₁ to R₄ in Formula (A) described above. Each of R₂₅ and R₂₆ independently represents a hydrogen atom or a hydrocarbon group which may have a substituent, and may form a cyclic structure by being bonded to each other. Specific examples and preferred aspects of the hydrocarbon group which may have a substituent are the same as those of R₁ to R₄ in Formula (A) described above.

In Formula (B), R₈ represents a hydrogen atom, a hydrocarbon group which may have a substituent, an alkoxy group, an alkylthio group, a hydroxy group, a mercapto group, -NR₂₇R₂₈, -N=CR₂₉R₃₀, or -CR₃₁=NR₃₂. Specific examples and preferred aspects of the hydrocarbon group which may have a substituent are the same as those of R₁ to R₄ in Formula (A) described above.

Each of R₂₇ to R₃₂ independently represents a hydrogen atom or a hydrocarbon group which may have a substituent. Specific examples and preferred aspects of the hydrocarbon group which may have a substituent are the same as those of R₁ to R₄ in Formula (A) described above. R₂₇ and R₂₈ may form a cyclic structure by being bonded to each other.

Here, there is no case where both of R₇ and Rs in Formula (B) represent an alkoxy group, a hydroxy group, an alkylthio group, or a mercapto group at the same time.

Furthermore, there is no case where all of R₅, R₇, and R₅ in Formula (B) represent -NR₁₉R₂₀, -NR₂₅R₂₆, or -NR₂₇R₂₈ at the same time. That is, there is no case where R₅, R₇, and R₈ represent -NR₁₉R₂₀, -NR₂₅R₂₆, and -NR₂₇R₂₈ respectively at the same time.

In Formula (B), each of R₅ to R₈ may form a cyclic structure by being bonded to each other. That is two or more groups selected from the group consisting of R₅ to R₈ may form a cyclic structure by being bonded to each other.

Two or more groups selected from the group consisting of R₅ to R₈ preferably form a cyclic structure by being bonded to each other.

In a case where R₅ forms a cyclic structure, the divalent group derived from R₅ in the cyclic structure is preferably a group selected from the group consisting of the following Formulae (a) to (f).

In a case where R₆ forms a cyclic structure, the divalent group derived from R₆ in the cyclic structure is preferably a divalent group selected from the group consisting of the following Formulae (a) to (d).

In a case where R₇ forms a cyclic structure, the divalent group derived from R₇ in the cyclic structure is preferably a divalent group selected from the group consisting of the following Formula (a) to (e), (g), and (h).

In a case where R₈ forms a cyclic structure, the divalent group derived from R₈ in the cyclic structure is preferably a divalent group selected from the group consisting of the following Formulae (a) to (h).

Here, there is no case where both of the "divalent group derived from R₇ in the cyclic structure" and the "divalent group derived from R₈ in the cyclic structure" are represented by the following (g) or (h) at the same time. Furthermore, there is no case where all of the "divalent group derived from R₅ in the cyclic structure", the "divalent group derived from R₇ in the cyclic structure", and the "divalent group derived from R₅ in the cyclic structure" are represented by the following Formula (e) at the same time.

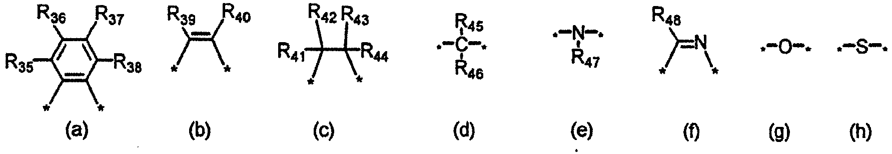

In Formulae (a) to (f), each of R₃₅ to R₄₈ independently represents a hydrogen atom or a substituent. Examples of the substituent include a substituent Q which will be described later.

In Formulae (a) to (h), each asterisk (*) represents a binding position. One of two asterisks represents a binding position of each group in Formula (B) and the other asterisk represents a binding position at the time when the groups are bonded to each other to form a cyclic structure. For example, in a case where R₅ and R₆ in Formula (B) form a cyclic structure by being bonded to each other; the divalent group derived from R₅ in the cyclic structure is a group represented by Formula (a); and the divalent group derived from R₆ in the cyclic structure is a group represented by Formula (b), one of the asterisks in Formulae (a) and (b) represents a position of binding to N⁺ in Formula (B), and the other asterisk in Formulae (a) and (b) represents a binding position at the time when R₅ and R₆ are bonded to each other.

Preferred aspects of the cation represented by Formula (B) will be shown below. Herein, Rₚ represents the group represented by R₅ or R₆ described above; R₅ represents the group represented by R₇ or R₈ described above; and each R independently represents a hydrogen atom or a substituent (for example, a substituent Q which will be described later).

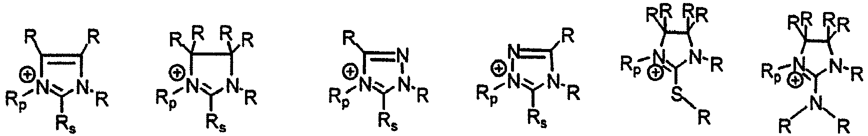

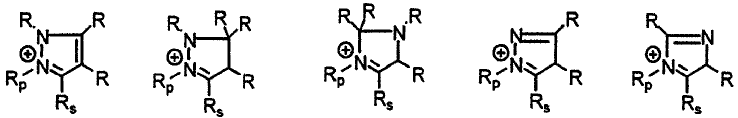

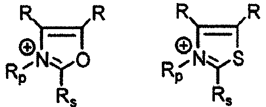

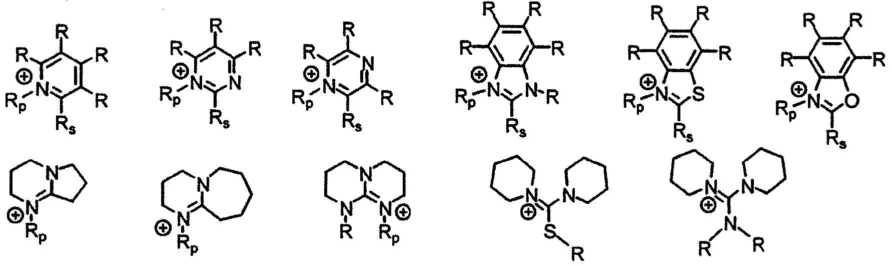

In Formula (C), R₉ represents either a hydrocarbon group which may have a substituent or -NR_{C1}R_{C2}. Specific examples and preferred aspects of the hydrocarbon group which may have a substituent are the same as those of R₁ to R₄ in Formula (A) described above.

Each of R_{C1} and R_{C2} independently represents a hydrogen atom or a hydrocarbon group which may have a substituent. Specific examples and preferred aspects of the hydrocarbon group which may have a substituent are the same as those of R₁ to R₄ in Formula (A) described above.

In Formula (C), R₁₀ represents a hydrogen atom or a hydrocarbon group which may have a substituent. Specific examples and preferred aspects of the hydrocarbon group which may have a substituent are the same as those of R₁ to R₄ in Formula (A) described above.

In Formula (C), R₁₁ represents a hydrocarbon group which may have a substituent, -CR₃₃=NR₃₄, or -NR_{C3}R_{C4}. Specific examples and preferred aspects of the hydrocarbon group which may have a substituent are the same as those of R₁ to R₄ in Formula (A) described above.

Each of R₃₃, R₃₄, R_{C3}, and R_{C4} independently represents a hydrogen atom or a hydrocarbon group which may have a substituent. Specific examples and preferred aspects of the hydrocarbon group which may have a substituent are the same as those of R₁ to R₄ in Formula (A) described above.

In Formula (C), each of R₉ to R₁₁ may form a cyclic structure by being bonded to each other. That is, two or more groups selected from the group consisting of R₉ to R₁₁ may form a cyclic structure by being bonded to each other.

Preferred aspects of the cation represented by Formula (C) will be shown below. Herein, Rₚ represents the group represented by R₉ or R₁₀ described above, and each R independently represents a hydrogen atom or a substituent (for example, a substituent Q which will be described later).

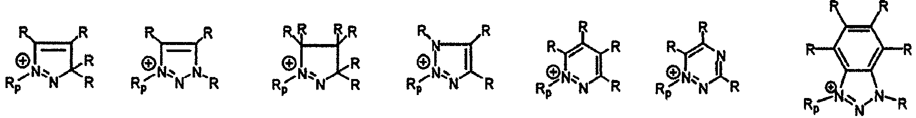

In Formula (D), each of R₁₂ to R₁₅ independently represents a hydrogen atom or a hydrocarbon group which may have a substituent. Specific examples and preferred aspects of the hydrocarbon group which may have a substituent are the same as those of R₁ to R₄ in Formula (A) described above.

Here, there is no case where all of R₁₂ to R₁₅ in Formula (D) represent a hydrogen atom at the same time. That is, Cⁿ⁺ is not PH₄⁺. In a case where Cⁿ⁺ is PH₄⁺, thermal stability deteriorates, and the compound (B) is easily decomposed at the time when a conductive film (electrode) is formed by sintering or the like. As a result, the insulation reliability of the obtained organic thin film transistor deteriorates.

In Formula (D), each of R₁₂ to R₁₅ may form a cyclic structure by being bonded to each other. That is, two or more groups selected from the group consisting of R₁₂ to R₁₅ may form a cyclic structure by being bonded to each other.

In Formula (E), each of R₁₆ to R₁₈ independently represents an alkyl group which may have a substituent. The alkyl group may be linear, branched, or cyclic. The number of carbon atoms of the alkyl group is not particularly limited, but is preferably 1 to 12. Examples of the substituent include a substituent Q, which will be described later, and the like.

As described above, each of R₁₆ to R₁₈ in Formula (E) independently represents an alkyl group which may have a substituent. In a case where any of R₁₆ to R₁₈ is a hydrocarbon group (for example, an aromatic hydrocarbon group) other than the alkyl group, the stability of the compound (B) in the electrode deteriorates, and as a result, the mobility of the organic thin film transistor deteriorates.

In Formula (E), each of R₁₆ to R₁₈ may form a cyclic structure by being bonded to each other. That is, two or more groups selected from the group consisting of R₁₆ to R₁₈ may form a cyclic structure by being bonded to each other.

Each of R₅ to R₃₄, R_{B1} to R_{B4}, and R_{C1} to R_{C4} described above may be a hydroxyalkyl group.

In a case where n in Formula (I) is 2 to 6 (that is, in a case where Cⁿ⁺ is a cation having a valency of 2 to 6), Cⁿ⁺ represents a cation having, as partial structures, n cations selected from the group consisting of Formulae (A) to (E) in the same molecule. That is, in a case where n in Formula (I) is 2 to 6, Cⁿ⁺ represents a cation having n partial structures, which are obtained by removing one or more hydrogen atoms from cations selected from the group consisting of Formulae (A) to (E), in the same molecule. Herein, Cⁿ⁺ may be either a cation having one kind of n partial structures or a cation having two or more kinds of a total of n partial structures.

In a case where n in Formula (I) is 2 to 6, Cⁿ⁺ is preferably a cation in which n cations selected from the group consisting of Formulae (A) to (E) are bonded to each other at any position through a single bond, a double bond, a triple bond, or a divalent linking group. Specific examples of the divalent linking group are as described above. Herein, Cⁿ⁺ may be either a cation in which one kind of n cations are bonded to each other or a cation in which two or more kinds of a total of n cations are bonded to each other.

### (Anion)

In Formula (I), A^{m-} represents an m-valent anion. Herein, m represents an integer of 1 to 3. That is, A^{m-} is an anion having a valency of 1 to 3.

A^{m-} is not an anion selected from the group consisting of Cl⁻, Br⁻, I⁻, PF₆⁻, R_{A1}CO₃⁻, R_{A10}NHCOO⁻, SbF₆⁻, and AsF₆⁻. Herein, each of R_{A1} and R_{A10} independently represents a hydrogen atom or a hydrocarbon group which may have a substituent. Specific examples of the hydrocarbon group which may have a substituent are the same as those of R₁ to R₄ in Formula (A) described above.

In a case where A^{m-} is an anion selected from the group consisting of Cl⁻, Br⁻, I⁻, PF₆⁻, R_{A1}CO₃⁻, R_{A10}NHCOO⁻, SbF₆⁻, and AsF₆⁻, the mobility or insulation reliability of the obtained organic thin film transistor becomes insufficient.

A^{m-} is preferably an anion selected from the group consisting of SO₄²⁻, R_{A2}SO₄⁻, R_{A3}SO₃⁻, PO₄³⁻, R_{A4}PO₄²⁻, (R_{A5})₂PO₄⁻, PO₃³⁻, R_{A6}PO₃²⁻, (R_{A7})₂PO₃⁻, [BF₄]⁻, [B(CN)₄]⁻, [B(C₆H₅)₄]⁻, CN⁻, OCN⁻, SCN⁻, [R_{A8}-COO]⁻, [(R_{A9}-SO₂)₂N]⁻, N(CN)₂⁻, and (R_{A11})₂NCS₂⁻, and more preferably an anion selected from the group consisting of SO₄²⁻ , R_{A2}SO₄⁻, R_{A3}SO₃⁻, and (R_{A5})₂PO₄⁻. A^{m-} is even more preferably an anion selected from the group consisting of SO₄²⁻, R_{A2}SO₄⁻, and R_{A3}SO₃⁻ because then the obtained organic thin film transistor exhibits higher mobility. Herein, each of R_{A2} to R_{A9} and R_{A11} independently represents a hydrogen atom or a hydrocarbon group which may have a substituent. Specific examples of the hydrocarbon group which may have a substituent are the same as those of R₁ to R₄ in Formula (A) described above.

R_{A2} is preferably a hydrogen atom or an alkyl group.

R_{A3} is preferably an alkyl group (particularly, an alkyl group having 1 to 12 carbon atoms) which may have a substituent, an aromatic hydrocarbon group (particularly, an aromatic hydrocarbon group having 6 to 18 carbon atoms) which may have a substituent, or a perfluoroalkyl group (a linear or branched alkyl group in which all of the hydrogen atoms are substituted with fluorine atoms).

It is preferable that each of R_{A4} and R_{A5} independently represents a hydrogen atom or an alkyl group.

It is preferable that each of R_{A6} and R_{A7} independently represents an aliphatic hydrocarbon group (particularly, an aliphatic hydrocarbon group having 1 to 12 carbon atoms) which may have a substituent.

R_{A8} is preferably a perfluoroalkyl group (a linear or branched alkyl group in which all of the hydrogen atoms are substituted with fluorine atoms).

R_{A9} is preferably an alkyl group (particularly, an alkyl group having 1 to 12 carbon atoms) which may have a substituent, and particularly preferably a perfluoroalkyl group (a linear or branched alkyl group in which all of the hydrogen atoms are substituted with fluorine atoms).

Each of R_{A1} to R_{A11} may be a hydroxyalkyl group.

In Formula (I), c represents an integer of 1 to 3, and a represents an integer of 1 to 6. c, n, a, and m in Formula (I) satisfy a relational expression of c × n = a × m. That is, the compound (B) is a neutrally charged salt composed of a cation (Cⁿ⁺) in a number of c and an anion (A^{m-}) in a number of a.

It is preferable that all of c, n, a, and m represent 1.

### (Substituent Q)

In the present specification, examples of the substituent Q include a halogen atom, an alkyl group (including a cycloalkyl group and a perfluoroalkyl group), an alkenyl group (including a cycloalkenyl group and a bicycloalkenyl group), an alkynyl group, an aryl group, a heterocyclic group, a cyano group, a hydroxy group, a nitro group, a carboxyl group, an alkoxy group, an aryloxy group, a silyloxy group, a heterocyclic oxy group, an acyloxy group, a carbamoyloxy group, an alkoxycarbonyloxy group, aryloxycarbonyloxy, an amino group (including an anilino group), an acylamino group, an aminocarbonylamino group, an alkoxycarbonylamino group, an aryloxycarbonylamino group, a sulfamoylamino group, alkyl and aryl sulfonylamino groups, a mercapto group, an alkylthio group, an arylthio group, a heterocyclic thio group, a sulfamoyl group, a sulfo group, alkyl and aryl sulfinyl groups, alkyl and aryl sulfonyl groups, an acyl group, an aryloxycarbonyl group, an alkoxycarbonyl group, a carbamoyl group, aryl and heterocyclic azo groups, an imide group, a phosphino group, a phosphinyl group, a phosphinyloxy group, a phosphinylamino group, a silyl group, a combination of these, and the like.

More specifically, examples of the substituent Q include a halogen atom (for example, a fluorine atom, a chlorine atom, a bromine atom, or an iodine atom), an alkyl group [(it means a substituted or unsubstituted linear, branched, or cyclic alkyl group and a perfluoroalkyl group (a linear or branched alkyl group in which all of the hydrogen atoms are substituted with fluorine atoms); these also include an alkyl group (preferably an alkyl group having 1 to 30 carbon atoms, for example, methyl, ethyl, n-propyl, isopropyl, t-butyl, n-octyl, eicosyl, 2-chloroethyl, 2-cyanoethyl, or 2-ethylhexyl), a perfluoroalkyl group (preferably a perfluoroalkyl group having 1 to 8 carbon atoms, for example, a trifluoromethyl group, a nonafluorobutyl group, or a tridecafluorohexyl group), a cycloalkyl group (preferably a substituted or unsubstituted cycloalkyl group having 3 to 30 carbon atoms, for example, cyclohexyl, cyclopentyl, or 4-n-dodecylcyclohexyl), a bicycloalkyl group (preferably a substituted or unsubstituted bicycloalkyl group having 5 to 30 carbon atoms, that is, a monovalent group obtained by removing one hydrogen atom from bicycloalkane having 5 to 30 carbon atoms, for example, bicyclo[1.2.2]heptan-2-yl or bicyclo[2.2.2]octan-3-yl), a tricyclo structure consisting of a large number of cyclic structures, and the like. An alkyl group in a substituent described below (for example, an alkyl group of an alkylthio group) also means the alkyl group having the concept described above],

an alkenyl group [it means a substituted or unsubstituted linear, branched, or cyclic alkenyl group; these also include an alkenyl group (preferably a substituted or unsubstituted alkenyl group having 2 to 30 carbon atoms, for example, vinyl, allyl, prenyl, geranyl, or oleyl), a cycloalkenyl group (preferably a substituted or unsubstituted cycloalkenyl group having 3 to 30 carbon atoms, that is, a monovalent group obtained by removing one hydrogen atom from cycloalkene having 3 to 30 carbon atoms, for example, 2-cyclopenten-1-yl or 2-cyclohexen-1-yl), and a bicycloalkenyl group (a substituted or unsubstituted bicycloalkenyl group and preferably a substituted or unsubstituted bicycloalkenyl group having 5 to 30 carbon atoms, that is, a monovalent group obtained by removing one hydrogen atom from bicycloalkene having one double bond, for example, bicyclo[2.2.1]hept-2-en-1-yl or bicyclo[2.2.2]oct-2-en-4-yl)], an alkynyl group (preferably a substituted or unsubstituted alkynyl group having 2 to 30 carbon atoms, for example, an ethynyl, propargyl, or trimethylsilylethynyl group),

an aryl group (preferably a substituted or unsubstituted aryl group having 6 to 30 carbon atoms, for example, phenyl, p-tolyl, naphthyl, m-chlorophenyl, or o-hexadecanoylaminophenyl), a heterocyclic group (preferably a monovalent group obtained by removing one hydrogen atom from a 5-membered or 6-membered substituted or unsubstituted aromatic or non-aromatic heterocyclic compound, more preferably, a 5-membered or 6-membered aromatic heterocyclic group having 3 to 30 carbon atoms, for example, 2-furanyl, 2-thienyl, 2-pyrimidinyl, or 2-benzothiazolinyl),

a cyano group, a hydroxy group, a nitro group, a carboxyl group, an alkoxy group (preferably a substituted or unsubstituted alkoxy group having 1 to 30 carbon atoms, for example, methoxy, ethoxy, isopropoxy, t-butoxy, n-octyloxy, or 2-methoxyethoxy), an aryloxy group (preferably a substituted or unsubstituted aryloxy group having 6 to 30 carbon atoms, for example, phenoxy, 2-methylphenoxy, 4-t-butylphenoxy, 3-nitrophenoxy, or 2-tetradecanoylaminophenoxy), a silyloxy group (preferably a silyloxy group having 3 to 20 carbon atoms, for example, trimethylsilyloxy or t-butyldimethylsilyloxy), a heterocyclic oxy group (preferably a substituted or unsubstituted heterocyclic oxy group having 2 to 30 carbon atoms, 1-phenyltetrazol-5-oxy or 2-tetrahydropyranyloxy), an acyloxy group (preferably a formyloxy group, a substituted or unsubstituted alkylcarbonyloxy group having 2 to 30 carbon atoms, or a substituted or unsubstituted arylcarbonyloxy group having 6 to 30 carbon atoms, for example, formyloxy, acetyloxy, pivaloyloxy, stearoyloxy, benzoyloxy, or p-methoxyphenylcarbonyloxy), a carbamoyloxy group (preferably a substituted or unsubstituted carbamoyloxy group having 1 to 30 carbon atoms, for example, N,N-dimethylcarbamoyloxy, N,N-diethylcarbamoyloxy, morpholinocarbonyloxy, N,N-di-n-octylaminocarbonyloxy, or N-n-octylcarbamoyloxy), an alkoxycarbonyloxy group (preferably a substituted or unsubstituted alkoxycarbonyloxy group having 2 to 30 carbon atoms, for example, methoxycarbonyloxy, ethoxycarbonyloxy, t-butoxycarbonyloxy, or n-octylcarbonyloxy), an aryloxycarbonyloxy group (preferably a substituted or unsubstituted aryloxycarbonyloxy group having 7 to 30 carbon atoms, for example, phenoxycarbonyloxy, p-methoxyphenoxycarbonyloxy, or p-n-hexadecyloxyphenoxycarbonyloxy),

an amino group (preferably an amino group, a substituted or unsubstituted alkylamino group having 1 to 30 carbon atoms, or a substituted or unsubstituted anilino group having 6 to 30 carbon atoms, for example, amino, methylamino, dimethylamino, anilino, N-methyl-anilino, or diphenylamino), an acylamino group (preferably a formylamino group, a substituted or unsubstituted alkylcarbonylamino group having 1 to 30 carbon atoms, or a substituted or unsubstituted arylcarbonylamino group having 6 to 30 carbon atoms, for example, formylamino, acetylamino, pivaloylamino, lauroylamino, benzoylamino, 3,4,5-tri-n-octyloxyphenylcarbonylamino), an aminocarbonylamino group (preferably substituted or unsubstituted aminocarbonylamino having 1 to 30 carbon atoms, for example, carbamoylamino, N,N-dimethylaminocarbonylamino, N,N-diethylaminocarbonylamino, or morpholinocarbonylamino), an alkoxycarbonylamino group (preferably a substituted or unsubstituted alkoxycarbonylamino group having 2 to 30 carbon atoms, for example, methoxycarbonylamino, ethoxycarbonylamino, t-butoxycarbonylamino, n-octadecyloxycarbonylamino, or N-methyl-methoxycarbonylamino), an aryloxycarbonylamino group (preferably a substituted or unsubstituted aryloxycarbonylamino group having 7 to 30 carbon atoms, for example, phenoxycarbonylamino, p-chlorophenoxycarbonylamino, or m-n-octyloxyphenoxycarbonylamino), a sulfamoylamino group (preferably a substituted or unsubstituted sulfamoylamino group having 0 to 30 carbon atoms, for example, sulfamoylamino, N,N-dimethylaminosulfonylamino, or N-n-octylaminosulfonylamino), alkyl and aryl sulfonylamino groups (preferably substituted or unsubstituted alkylsulfonylamino having 1 to 30 carbon atoms and substituted or unsubstituted arylsulfonylamino having 6 to 30 carbon atoms, for example, methylsulfonylamino, butylsulfonylamino, phenylsulfonylamino, 2,3,5-trichlorophenylsulfonylamino, or p-methylphenylsulfonylamino),

a mercapto group, an alkylthio group (preferably a substituted or unsubstituted alkylthio group having 1 to 30 carbon atoms, for example, methylthio, ethylthio, or n-hexadecylthio), an arylthio group (preferably substituted or unsubstituted aryltho having 6 to 30 carbon atoms, for example, phenylthio, p-chlorophenylthio, or m-methoxyphenylthio), a heterocyclic thio group (preferably a substituted or unsubstituted heterocyclic thio group having 2 to 30 carbon atoms, for example, 2-benzothiazolylthio or 1-phenyltetrazol-5-ylthio), a sulfamoyl group (preferably a substituted or unsubstituted sulfamoyl group having 0 to 30 carbon atoms, for example, N-ethylsulfamoyl, N-(3-dodecyloxypropyl)sulfamoyl, N,N-dimethylsulfamoyl, N-acetylsulfamoyl, N-benzoylsulfamoyl, or N-(N'-phenylcarbamoyl)sulfamoyl), a sulfo group, alkyl and aryl sulfinyl groups (preferably a substituted or unsubstituted alkylsulfinyl group having 1 to 30 carbon atoms and a substituted or unsubstituted arylsulfinyl group having 6 to 30 carbon atoms, for example, methylsulfinyl, ethylsulfinyl, phenylsulfinyl, or p-methylphenylsulfinyl),

alkyl and aryl sulfonyl groups (preferably a substituted or unsubstituted alkylsulfonyl group having 1 to 30 carbon atoms and a substituted or unsubstituted arylsulfonyl group having 6 to 30 carbon atoms, for example, methylsulfonyl, ethylsulfonyl, phenylsulfonyl, and p-methylphenylsulfonyl), an acyl group (preferably a formyl group, a substituted or unsubstituted alkylcarbonyl group having 2 to 30 carbon atoms, a substituted or unsubstituted arylcarbonyl group having 7 to 30 carbon atoms, or a substituted or unsubstituted heterocyclic carbonyl group having 4 to 30 carbon atoms that is bonded to a carbonyl group through carbon atoms, for example, acetyl, pivaloyl, 2-chloroacetyl, stearoyl, benzoyl, p-n-octyloxyphenylcarbonyl, 2-pyridylcarbonyl, or 2-furylcarbonyl), an aryloxycarbonyl group (preferably a substituted or unsubstituted aryloxycarbonyl group having 7 to 30 carbon atoms, for example, phenoxycarbonyl, o-chlorophenoxycarbonyl, m-nitrophenoxycarbonyl, or p-t-butylphenoxycarbonyl), an alkoxycarbonyl group (preferably a substituted or unsubstituted alkoxycarbonyl group having 2 to 30 carbon atoms, for example, methoxycarbonyl, ethoxycarbonyl, t-butoxycarbonyl, or n-octadecyloxycarbonyl),

a carbamoyl group (preferably substituted or unsubstituted carbamoyl having 1 to 30 carbon atoms, for example, carbamoyl, N-methylcarbamoyl, N,N-dimethylcarbamoyl, N,N-di-n-octylcarbamoyl, or N-(methylsulfonyl)carbamoyl), aryl and heterocyclic azo groups (preferably a substituted or unsubstituted arylazo group having 6 to 30 carbon atoms and a substituted or unsubstituted heterocyclic azo group having 3 to 30 carbon atoms, for example, phenylazo, p-chlorophenylazo, and 5-ethylthio-1,3,4-thiadiazol-2-ylazo); an imide group (preferably N-succinimide or N-phthalimide), a phosphino group (preferably a substituted or unsubstituted phosphino group having 2 to 30 carbon atoms, for example, dimethylphosphino, diphenylphosphino, or methylphenoxyphosphino), a phosphinyl group (preferably a substituted or unsubstituted phosphinyl group having 2 to 30 carbon atoms, for example, phosphinyl, dioctyloxyphosphinyl, or diethoxyphosphinyl), a phosphinyloxy group (preferably a substituted or unsubstituted phosphinyloxy group having 2 to 30 carbon atoms, for example, diphenoxyphosphinyloxy or dioctyloxyphosphinyloxy), a phosphinylamino group (preferably a substituted or unsubstituted phosphinylamino group having 2 to 30 carbon atoms, for example, dimethoxyphosphinylamino or dimethylaminophosphinylamino), or a silyl group (preferably a substituted or unsubstituted silyl group having 3 to 30 carbon atoms, for example, trimethylsilyl, t-butyldimethylsilyl, or phenyldimethylsilyl).

The content of the compound (B) in the composition of the present invention is not particularly limited. However, a ratio of the content of the compound (B) to the content of the metal particles (A) is preferably 0.1% by mass to 20.0% by mass, more preferably 1.0% by mass to 10.0% by mass because then the obtained organic thin film transistor exhibits better insulating properties, and even more preferably 3.0% by mass to 8.0% by mass.

A ratio of the content of the compound (B) to the total amount of the composition is not particularly limited, but is preferably 0.01% by mass to 15% by mass and more preferably 0.5% by mass to 5.0% by mass. The ratio of the content of the compound (B) to the total amount of the composition is even more preferably equal to or greater than 1.0% by mass because then the obtained organic thin film transistor exhibits better insulating properties.

### <Optional components>

### (Solvent)

From the viewpoint of ease of regulating viscosity and coating properties, the composition of the present invention preferably contains a solvent. The solvent functions as a dispersion medium of the metal particles (A).

The type of the solvent is not particularly limited, and for example, water, organic solvents such as alcohols, ethers, and esters, and the like can be used. Among these, water is preferable.

The content of the solvent is not particularly limited. However, it is preferably 20% by mass to 90% by mass with respect to the total amount of the composition because then the increase in viscosity is inhibited and thus the handleability is improved.

### (Other components)

The composition of the present invention may contain components other than the components described above. For example, the composition of the present invention may contain a dispersing agent, a surfactant, and the like.

### <Method for preparing conductive film forming composition>

The method for preparing the composition of the present invention is not particularly limited, and known methods can be adopted. For example, the composition can be obtained by a method in which the metal particles (A) and the compound (B) are added to the aforementioned solvent, and then the solution is stirred by known means such as an ultrasonic method (for example, a treatment performed using an ultrasonic homogenizer), a mixer method, a triple roll method, or a ball mill method.

The composition of the present invention is useful as a conductive film forming composition for forming an electrode of a field effect transistor (particularly, an organic thin film transistor). The electrode may be any of a source electrode, a drain electrode, and a gate electrode. Particularly, the composition of the present invention is useful for a source electrode and a drain electrode.

Furthermore, as described above, the compound (B) contained in the composition of the present invention functions as a migration inhibitor and hence brings about excellent insulation reliability. Therefore, the composition of the present invention is also useful as a conductive film forming composition for forming wiring of a wiring board (for example, printed wiring board) and the like.

### [Organic thin film transistor]

The organic thin film transistor of the present invention is an organic thin film transistor including electrodes (particularly, a source electrode and a drain electrode) formed using the composition of the present invention described above. The organic thin film transistor may be a bottom contact type (a bottom gate-bottom contact type or a top gate-bottom contact type) or a top contact type (a bottom gate-top contact type or a top gate-top contact type).

An aspect of the organic thin film transistor of the present invention will be described with reference to a drawing.

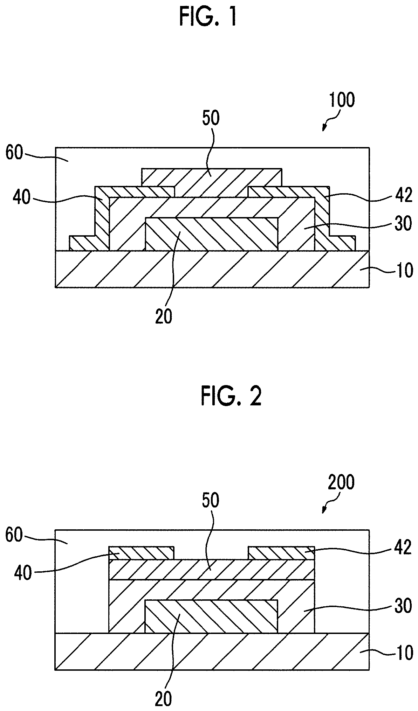

Fig. 1 is a schematic sectional view of an aspect of the organic thin film transistor of the present invention.

In Fig. 1, an organic thin film transistor 100 includes a substrate 10, a gate electrode 20 which is disposed on the substrate 10, a gate insulating film 30 which covers the gate electrode 20, a source electrode 40 and a drain electrode 42 which come into contact with the surface, which is opposite to the gate electrode 20 side, of the gate insulating film 30, an organic semiconductor layer 50 which covers the surface of the gate insulating film 30 between the source electrode 40 and the drain electrode 42, and a sealing layer 60 which covers the respective members. The organic thin film transistor 100 is a bottom gate-bottom contact type organic thin film transistor.

In Fig. 1, the source electrode 40 and the drain electrode 42 are formed using the composition of the present invention described above, but the present invention is not limited to this aspect. It is preferable that at least one of the source electrode 40, the drain electrode 42, and the gate electrode 20 is formed using the composition of the present invention. For example, all of the gate electrode 20, the source electrode 40, and the drain electrode 42 may be formed using the composition of the present invention, or only the source electrode 40 (alternatively, the drain electrode 42) may be formed using the composition of the present invention.

Hereinafter, the substrate, the gate electrode, the gate insulating film, the source electrode, the drain electrode, the organic semiconductor layer, the sealing layer, and methods for forming each of these will be specifically described.

### <Substrate>

The substrate plays a role of supporting the gate electrode, the source electrode, the drain electrode, and the like which will be described later.

The type of the substrate is not particularly limited, and examples thereof include a plastic substrate, a glass substrate, a ceramic substrate, and the like. Among these, from the viewpoint of the applicability to various devices, a glass substrate or a plastic substrate is preferable.

Examples of the material of the plastic substrate include a thermosetting resin (for example, an epoxy resin, a phenol resin, a polyimide resin, or a polyester resin (for example, PET or PEN)) and a thermoplastic resin (for example, a phenoxy resin, polyethersulfone, polysulfone, or polyphenylene sulfone).

Examples of the material of the ceramic substrate include alumina, aluminum nitride, zirconia, silicon, silicon nitride, silicon carbide, and the like.

Examples of the material of the glass substrate include soda glass, potash glass, borosilicate glass, quartz glass, aluminosilicate glass, lead glass, and the like.

### <Gate electrode>

Examples of the material of the gate electrode include a metal such as gold (Au), silver, aluminum (Al), copper, chromium, nickel, cobalt, titanium, platinum, magnesium, calcium, barium, or sodium; a conductive oxide such as InO₂, SnO₂, or 1TO; a conductive polymer such as polyaniline, polypyrrole, polythiophene, polyacetylene, or polydiacetylene; a semiconductor such as silicon, germanium, or gallium arsenide; a carbon material such as fullerene, carbon nanotubes, or graphite; and the like. Among these, a metal is preferable, and silver or aluminum is more preferable.

The thickness of the gate electrode is not particularly limited but is preferably 20 nm to 200 nm.

The method for forming the gate electrode is not particularly limited. Examples of the method include a method of vacuum vapor-depositing or sputtering an electrode material onto a substrate, a method of coating a substrate with a composition for forming an electrode, a method of printing a composition for forming an electrode on a substrate, and the like. Furthermore, in a case where the electrode is patterned, examples of the patterning method include a photolithography method; a printing method such as ink jet printing, screen printing, offset printing, or relief printing; a mask vapor deposition method; and the like.

### <Gate insulating film>

Examples of the material of the gate insulating film include a polymer such as polymethyl methacrylate, polystyrene, polyvinylphenol, polyimide, polycarbonate, polyester, polyvinylalcohol, polyvinyl acetate, polyurethane, polysulfone, polybenzoxazole, polysilsesquioxane, an epoxy resin, or a phenol resin; an oxide such as silicon dioxide, aluminum oxide, or titanium oxide; a nitride such as silicon nitride; and the like. Among these materials, in view of the compatibility with the organic semiconductor layer, a polymer is preferable.

In a case where a polymer is used as the material of the gate insulating film, it is preferable to concurrently use a cross-linking agent (for example, melamine). By the concurrent use of the cross-linking agent, the polymer is cross-linked, and the durability of the formed gate insulating film is improved.

The film thickness of the gate insulating film is not particularly limited, but is preferably 100 nm to 1,000 nm.

The method for forming the gate insulating film is not particularly limited, but examples thereof include a method of coating a substrate, on which the gate electrode is formed, with a composition for forming a gate insulating film, a method of vapor-depositing or sputtering the material of the gate insulating film onto the substrate on which the gate electrode is formed, and the like. The method for coating the aforementioned substrate with the composition for forming a gate insulating film is not particularly limited, and it is possible to use a known method (a bar coating method, a spin coating method, a knife coating method, or a doctor blade method).

In a case where the gate insulating film is formed by coating the substrate with the composition for forming a gate insulating film, for the purpose of removing the solvent, causing cross-linking, or the like, the composition may be heated (baked) after coating.

### <Source electrode and drain electrode>

As described above, the source electrode and the drain electrode are formed using the composition of the present invention described above.

The channel length of the source electrode and the drain electrode is not particularly limited, but is preferably 5 µm to 100µm.

The channel width of the source electrode and the drain electrode is not particularly limited, but is preferably 50 µm to 500 µm.

The method for forming the source electrode and the drain electrode is not particularly limited, but examples thereof include a method including a coating film forming step and a sintering step. Hereinafter, each of the steps will be described.

### (Coating film forming step)

This is a step of coating the substrate, on which the gate electrode and the gate insulating film are formed, with the composition of the present invention described above.

The method for forming a coating film by coating the substrate with the composition of the present invention is not particularly limited, and known methods can be adopted.

Examples of the method of coating includes a coating method, a screen printing method, a dip coating method, a spray coating method, a spin coating method, an ink jet method, and the like using a double roll coater, a slit coater, an air knife coater, a wire bar coater, a slide hopper, a spray coater, a blade coater, a doctor coater, a squeeze coater, a reverse roll coater, a transfer roll coater, an extrusion coater, a curtain coater, a dip coater, a die coater, and a gravure roll.

After the substrate is coated with the composition of the present invention, if necessary, in order to remove the solvent, a drying treatment may be performed. As the method of the drying treatment, methods known in the related art can be used.

### (Sintering step)

This is a step of forming a conductive film by sintering the metal particles (A) in the composition by applying heat energy or light energy to the coating film formed by the coating film forming step by means of heating or light irradiation.

The heating conditions are not particularly limited. However, the heating temperature is preferably 100°C to 300°C, and the heating time is more preferably 10 minutes to 60 minutes.

The heating means is not particularly limited, and known heating means such as an oven and a hot plate can be used.

The light source used for the light irradiation treatment is not particularly limited, and examples thereof include a mercury lamp, a metal halide lamp, a xenon (Xe) lamp, a chemical lamp, a carbon arc lamp, and the like.

### <Organic semiconductor layer>

The organic semiconductor material constituting the organic semiconductor layer is not particularly limited, and known materials used as an organic semiconductor layer of organic semiconductor transistors can be used. Specific examples of the organic semiconductor material include pentacenes such as 6,13-bis(triisopropylsilylethynyl)pentacene (TIPS pentacene), tetramethyl pentacene, and perfluoropentacene, anthradithiophenes such as TES-ADT and diF-TES-ADT (2,8-difluoro-5,11-bis(triethylsilylethynyl)anthradithiophene), benzothienobenzothiophenes such as DPh-BTBT and Cn-BTBT, dinaphthothienothiophenes such as Cn-DNTT, dioxaanthanthrenes such as peri-xanthenoxanthene, rubrenes, fullerenes such as C60 and PCBM, phthalocyanines such as copper phthalocyanine and fluorinated copper phthalocyanine, polythiophenes such as P3RT, PQT, and P3HT, polythienothiophenes such as poly[2,5-bis(3-dodecylthiophen-2-yl)thieno[3,2-b]thiophene] (PBTTT), and the like.

The thickness of the organic semiconductor layer is not particularly limited but is preferably 10 nm to 200 nm.

The method for forming the organic semiconductor layer is not particularly limited. Examples of the method include a method of coating the substrate, on which the gate electrode, the gate insulating film, the source electrode, and the drain electrode are formed, with a composition for an organic semiconductor layer obtained by dissolving an organic semiconductor material in a solvent, and the like. Specific examples of the method of coating the substrate with the composition for an organic semiconductor layer are the same as the method of coating the substrate with the composition for forming a gate insulating film. In a case where the organic semiconductor layer is formed by coating the substrate with the composition for an organic semiconductor layer, for the purpose of removing the solvent, causing crosslinking, or the like, the composition may be heated (baked) after coating.

### <Sealing layer>

From the viewpoint of durability, the organic thin film transistor of the present invention preferably includes a sealing layer as the outermost layer. For the sealing layer, a known sealant can be used.

The thickness of the sealing layer is not particularly limited but is preferably 0.2 µm to 10 µm.

The method for forming the sealing layer is not particularly limited. Examples of the method include a method of coating the substrate, on which the gate electrode, the gate insulating film, the source electrode, the drain electrode, and the organic semiconductor layer are formed, with a composition for forming a sealing layer, and the like. Specific examples of the method of coating the substrate with the composition for forming a sealing layer are the same as the examples of the method of coating the substrate with the composition for forming a gate insulating film. In a case where the organic semiconductor layer is formed by coating the substrate with the composition for forming a sealing layer, for the purpose of removing the solvent, causing crosslinking, or the like, the composition may be heated (baked) after coating.

Fig. 2 is a schematic sectional view of another aspect of the organic thin film transistor of the present invention.

In Fig. 2, an organic thin film transistor 200 includes the substrate 10, the gate electrode 20 which is disposed on the substrate 10, the gate insulating film 30 which covers the gate electrode 20, the organic semiconductor layer 50 which is disposed on the gate insulating film 30, the source electrode 40 and the drain electrode 42 which are disposed on the organic semiconductor layer 50, and the sealing layer 60 which covers the respective members. Herein, the source electrode 40 and the drain electrode 42 are formed by using the composition of the present invention described above. The organic thin film transistor 200 is a top contact-type organic thin film transistor.

The substrate, the gate electrode, the gate insulating film, the source electrode, the drain electrode, the organic semiconductor layer, and the sealing layer are as described above.

The organic thin film transistor described above can be suitably used in electronic paper, a display device, and the like.

### Examples

Hereinafter, examples will be described, but the present invention is not limited thereto.

### <Preparation of silver ink A1>

As a dispersing agent, Disperbyk-190 (manufactured by BYK) (7.36 g as nonvolatile matter) was dissolved in water (100 mL) (solution a). Then, 50.00 g (294.3 mmol) of silver nitrate was dissolved in water (200 mL) (solution b). The solution a and the solution b were mixed and stirred together. To the obtained mixture, 85% by mass aqueous N,N-diethylhydroxylamine solution (78.71 g) (750.5 mmol as N,N-diethylhydroxylamine) was slowly added dropwise at room temperature. Thereafter, a solution obtained by dissolving Disperbyk-190 (7.36 g) in water (1,000 mL) was slowly added dropwise thereto at room temperature. Through an ultrafiltration unit (Vivaflow 50 manufactured by Sartorius Stedim Biotech, molecular weight cut-off: 100,000, number of units: 4), the obtained suspension was purified by passing purified water through the unit until approximately 5 L of leachate was obtained from the ultrafiltration unit. The supply of the purified water was stopped, and concentration was performed, thereby obtaining 50 g of silver nanoparticle dispersion (silver ink Al). The content of solids in the silver ink A1 was 32% by mass. Furthermore, as a result of measuring the content of silver in the solids by TG-DTA, it was confirmed that the content of silver was 97.0% by mass. Herein, as a result of measuring the particle size of the silver nanoparticles by using a concentrated system particle size analyzer FPAR-1000 (manufactured by OTSUKA ELECTRONICS Co., LTD), it was confirmed that the average particle size of the silver nanoparticles was 60 nm.

### <Examples 1 to 9 and Comparative examples 1 to 11>

Silver inks A2 to A7 and A19 to A21 (conductive film forming compositions of Examples 1 to 9, where examples 3-5, 8 and 9 are not forming part of the invention) and silver inks A8 to A18 (conductive film forming compositions of Comparative examples 1 to 11) were prepared according to the same procedure as used in the preparation of the silver ink A1, except that at the time of mixing the solution a with the solution b, in addition to the solution a and the solution b, a migration inhibitor shown in Table 1 was also formulated according to the "ratio of content of migration inhibitor to total amount of silver ink" shown in Table 1.

### <Evaluation of insulation reliability>

By a spray coating method, a substrate obtained by laminating ABF-GX13 (manufactured by Ajinomoto Fine-Techno Co., Inc.) on an FR4 glass epoxy sheet was coated with the silver ink A1 by using STS-200 (manufactured by YD Mechatronic Solutions Inc.) such that the film thickness after sintering became 200 nm. Then, the silver ink A1 was sintered (210°C, 1 hour) using an oven, thereby forming a silver film on the substrate. The formed silver film was etched in a comb shape at L/S = 50/50 µm by a photolithography method, thereby forming a comb-shaped silver film (silver wiring). At this time, Photec 7025 (manufactured by Hitachi Chemical Co., Ltd.) was used as a dry photoresist, and Agrip 940 (manufactured by Meltex Inc.) was used as a silver etching solution. In addition, the silver wiring was spin-coated with Cytop CTL107MK (manufactured by ASAHI GLASS CO., LTD.) such that the film thickness after drying became 1 µm, followed by drying at 140°C for 20 minutes in an oven, thereby forming a sealing layer. In this way, a wiring board for evaluating insulation reliability was prepared.

For the obtained wiring board, a service life test was performed under the conditions of a humidity of 85%, a temperature of 85°C, a pressure of 1.0 atm, and a voltage of 60 V (used apparatus: EHS-221MD manufactured by ESPEC Corp). Specifically, in the aforementioned environment, the aforementioned voltage was applied to the silver wirings adjacent to each other. Then, a time taken for a short circuit to occur between the silver wirings due to electrochemical migration (time T taken for a value of resistance between silver wirings to become 1 × 10⁵ Ω) was measured. A time T taken in a case where the silver ink A1 was used was denoted by T1 (standard).

Subsequently, by using silver inks A2 to A21 (conductive film forming compositions of examples and comparative examples) to which the migration inhibitor was added, wiring boards for evaluating insulation reliability were prepared in the same manner as in the case of the silver ink A1, and the service life thereof was measured. A time T taken in a case where a silver ink An (n = 2 to 21) was used was denoted by Tn.

For silver inks A2 to A21 (conductive film forming compositions of examples and comparative examples), Tn/Tl was calculated, and the insulation reliability was evaluated according to the following criteria. The results are shown in Table 1. For practical use, the silver ink is preferably evaluated to be A to C, more preferably evaluated to be A or B, and even more preferably evaluated to be A.
"A": a case where Tn/T1 ≥ 5
"B": a case where 5 > Tn/Tl ≥ 2
"C": a case where 2 > Tn/T1 ≥ 1
"D": a case where 1 ≥ Tn/T1

### <Evaluation of mobility>

A1 to be a gate electrode was vapor-deposited (thickness: 50 nm) onto a glass substrate (Eagle XG: manufactured by Coming). The A1 was spin-coated with a composition for forming a gate insulating film (a propylene glycol monomethyl ether acetate (PGMEA) solution (concentration of solid content: 2% by mass) of polyvinylphenol/melamine = 1 part by mass/1 part by mass (w/w)), followed by baking for 60 minutes at 150°C, thereby forming a gate insulating film having a film thickness of 400 nm. Onto the gate insulating film, by using the silver ink A1, patterns of a source electrode and a drain electrode (channel length: 40 µm, channel width: 200 µm) were drawn using an ink jet apparatus DMP-2831 (manufactured by FUJIFILM Dimatix, Inc.). The silver ink A1 was then sintered by being baked for 30 minutes at 180°C in an oven, thereby forming source and drain electrodes. The source electrode and the drain electrode were spin-coated with a toluene solution of 2,8-difluoro-5,11-bis(triethylsilylethynyl)anthradithiophene (manufactured by Sigma-Aldrich Co, LLC.), followed by baking for 15 minutes at 140°C, thereby forming an organic conductive layer having a thickness of 100 nm. The organic semiconductor layer was spin-coated with Cytop CTL-107MK (manufactured by ASAHI GLASS CO., LTD.), followed by baking for 20 minutes at 140°C, thereby forming a sealing layer (uppermost layer) having a thickness of 2 µm. In this way, an organic thin film transistor (bottom contact-type) was prepared.

The electrodes of the obtained organic thin film transistor were respectively connected to the terminals of a manual prober connected to a semiconductor parameter/analyzer (4155C, manufactured by Agilent Technologies Inc.), thereby evaluating the field effect transistor (FET). Specifically, by measuring the drain current-gate voltage (Id-Vg) characteristics, the field effect mobility ([cm²V·sec]) was calculated. A total of five organic thin film transistors was calculated. The average of the field effect mobility of the five organic thin film transistors, in which the silver ink A1 was used for the source electrode and the drain electrode, was denoted by µl.

Then, by using the silver inks A2 to A21 (conductive film forming compositions of examples and comparative examples) to which the migration inhibitor was added, organic thin film transistors were prepared in the same manner as in the case of the silver ink A1, and the average of the field effect mobility thereof was calculated. The average of the field effect mobility in a case where a silver ink An (n = 2 to 21) was used was denoted by µn.

For the silver inks A2 to A21 (conductive film forming compositions of examples and comparative examples), µn/µl was calculated, and the mobility was evaluated according to the following criteria. The results are shown in Table 1. For practical use, the silver ink is preferably evaluated to be A to C, more preferably evaluated to be A or B, and even more preferably evaluated to be A.
"A": µn/µl ≥ 0.8
"B": 0.8 > µn/µl ≥ 0.5
"C": 0.5 > µη/µl ≥ 0.1
"D": 0.1 > µn/µl

Details of the migration inhibitors in Table 1 are as below. Note that not all of the migration inhibitors M1-M18 are according to Formula (I).
·M1: tosic acid pyridinium salt 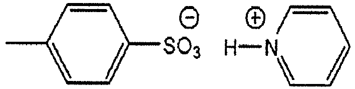
·M2: tosic acid tetramethyl ammonium salt 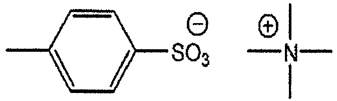
·M3: phosphoric acid diethyltetramethyl ammonium salt 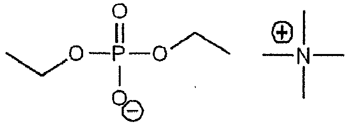
·M4: tosic acid dimethylphenyl ammonium salt 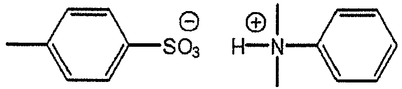
·M5: triaryl sulfonium trifluoromethanesulfonate
·M6: octadecyl benzoate
·M7: fluoroantimonic acid salt (following structure) 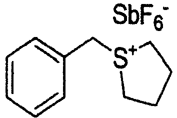
·M8: N-butylpyridinium hexafluorophosphate
·M9: dodecylsulfonic acid triethanolamine salt
·M10: hexoxybenzoic acid (following structure) 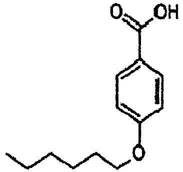
·M11: 2-ethylhexylammonium 2-ethylhexylcarbamate
·M12: hexafluorophosphoric acid triethanolamine salt
·M13: p-toluenesulfonic acid ammonium salt
·M14: 1-ethyl-1-methylpyrrolidinium bromide
·M15: tetrabutylammonium chloride
·M16: a compound represented by the following formula 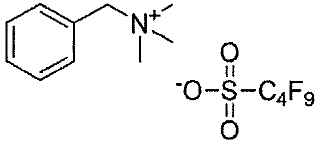
·M17: a compound represented by the following formula 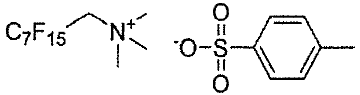
·M18: a compound represented by the following formula

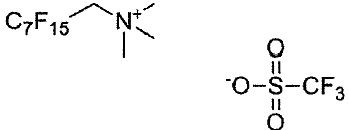

**[Table 1] (Examples 3-5, 8 and 9 do not form part of the invention)**

| Table 1 (part 1) | Example 1 | Example 2 | Example 3 | Example 4 | Example 5 | Example 6 | Example 7 | Example 8 | Example 9 |
|---|---|---|---|---|---|---|---|---|---|
| Silver ink | A2 | A3 | A4 | A5 | A6 | A7 | A19 | A20 | A21 |
| Migration inhibitor | M1 | M1 | M2 | M2 | M3 | M4 | M16 | M17 | M18 |
| Ratio of content of migration inhibitor to total amount of silver ink (% by mass) | 2 | 5 | 0.5 | 2 | 2 | 2 | 2 | 2 | 2 |
| Insulation reliability | A | A | B | A | B | A | A | B | B |
| Mobility | A | A | B | B | A | A | B | A | A |

**[Table 2]**

| Table 1 (part 2) | Comparative example 1 | Comparative example 2 | Comparative example 3 | Comparative example 4 | Comparative example 5 | Comparative example 6 |
|---|---|---|---|---|---|---|
| Silver ink | A8 | A9 | A10 | All | A12 | A13 |
| Migration inhibitor | M5 | M6 | M7 | M8 | M9 | M10 |
| Ratio of content of migration inhibitor to total amount of silver ink (% by mass) | 2 | 2 | 2 | 2 | 2 | 2 |
| Insulation reliability | B | D | B | B | B | D |
| Mobility | D | C | D | D | D | C |

**[Table 3]**

| Table 1 (part 3) | Comparative example 7 | Comparative example 8 | Comparative example 9 | Comparative example 10 | Comparative example 11 |
|---|---|---|---|---|---|
| Silver ink | A14 | A15 | A16 | A17 | A18 |
| Migration inhibitor | M11 | M12 | M13 | M14 | M15 |
| Ratio of content of migration inhibitor to total amount of silver ink (% by mass) | 2 | 2 | 2 | 2 | 2 |
| Insulation reliability | D | B | D | D | D |
| Mobility | B | D | B | D | D |

As is evident from Table 1, all of the organic thin film transistors having electrodes formed using the conductive film forming compositions of Examples 1 to 9 containing the compound (B) exhibited excellent insulation reliability and high mobility, with the non-inventive examples 3-5, 8 and 9 showing lower insulation reliability and lower mobility than the inventive examples.

Through the comparison between non-inventive Examples 3 and 4, it was confirmed that the insulation reliability was better in non-inventive Example 4 in which the ratio of the content of the compound (B) to the total amount of the composition (ratio of the content of the migration inhibitor to the total amount of the silver ink) was equal to or greater than 1.0% by mass.

Furthermore, through the comparison between non-inventive Examples 4 and 5, it was confirmed that the insulation reliability was better in non-inventive Example 4 in which A^{m-} in Formula (I) was an anion selected from the group consisting of SO₄²⁻, R_{A2}SO₄⁻, and R_{A3}SO₃⁻.

In addition, through the comparison between non-inventive Example 4 and inventive Example 6, it was confirmed that the mobility was higher in Example 6 in which at least one of R₁ to R₄ in Formula (I) was an aromatic hydrocarbon group.

In contrast, in the organic thin film transistors having electrodes formed using the conductive film forming compositions of Comparative examples 1 to 11 not containing the compound (B), either or both of the insulation reliability and the mobility were insufficient.

### Explanation of References

- 10:: substrate
- 20:: gate electrode
- 30:: gate insulating film
- 40:: source electrode
- 42:: drain electrode
- 50:: organic semiconductor layer
- 60:: sealing layer
- 100, 200:: organic thin film transistor

## Claims

1. A conductive film forming composition comprising:
metal particles A; and
a compound B represented by the following Formula (I),
cCⁿ⁺aA^{m-} Formula (I)
in Formula (I), Cⁿ⁺ represents an n-valent cation; n represents an integer of 1 to 6; in a case where n is 1, Cⁿ⁺ represents a cation selected from the group consisting of the following Formulae (A) to (E); and in a case where n is 2 to 6, Cⁿ⁺ represents a cation having, as a partial structure, n cations selected from the group consisting of the following Formulae (A) to (E) in the same molecule,
in Formula (I), A^{m-} represents an m-valent anion excluding anions selected from the group consisting of Cl⁻, Br⁻, I⁻, PF₆⁻, R_{A1}CO₃⁻, R_{A10}NHCOO⁻, SbF₆⁻, and AsF₆⁻; each of R_{A1} and R_{A10} independently represents a hydrogen atom or a hydrocarbon group which may have a substituent; and m represents an integer of 1 to 3,
in Formula (I), c represents an integer of 1 to 3; a represents an integer of 1 to 6; and c, n, a, and m satisfy a relational expression of c × n = a × m, 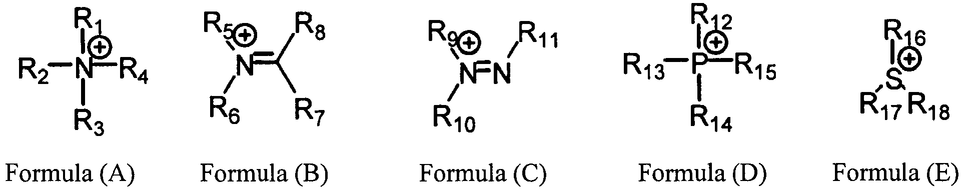
in Formula (A), each of R₁ to R₄ independently represents a hydrogen atom or a hydrocarbon group which may have a substituent; none of R₁ to R₄ is a hydroxyalkyl group; there is no case where all of R₁ to R₄ represent a hydrogen atom at the same time; each of R₁ to R₄ may form a cyclic structure by being bonded to each other; and at least one of R₁ to R₄ is an aromatic hydrocarbon group,
in Formula (B), R₅ represents a hydrocarbon group which may have a substituent, -NR₁₉R₂₀, -N=CR₂₁R₂₂, -CR₂₃=NR₂₄, or -CR_{B1}R_{B2}-NR_{B3}R_{B4}; each of R₁₉ to R₂₄ and R_{B1} to R_{B4} independently represents a hydrogen atom or a hydrocarbon group which may have a substituent; and each of R₁₉ and R₂₀ may form a cyclic structure by being bonded to each other,
in Formula (B), R₆ represents a hydrogen atom or a hydrocarbon group which may have a substituent,
in Formula (B), R₇ represents a hydrogen atom, a hydrocarbon group which may have a substituent, an alkoxy group, an alkylthio group, a hydroxy group, a mercapto group, or -NR₂₅R₂₆; and each of R₂₅ and R₂₆ independently represents a hydrogen atom or a hydrocarbon group which may have a substituent, and may form a cyclic structure by being bonded to each other,
in Formula (B), R₈ represents a hydrogen atom, a hydrocarbon group which may have a substituent, an alkoxy group, an alkylthio group, a hydroxy group, a mercapto group, -NR₂₇R₂₈, -N=CR₂₉R₃₀, or -CR₃₁=NR₃₂; each of R₂₇ to R₃₂ independently represents a hydrogen atom or a hydrocarbon group which may have a substituent; and R₂₇ and R₂₈ may form a cyclic structure by being bonded to each other,
there is no case where both of R₇ and R₈ represent an alkoxy group, a hydroxy group, an alkylthio group, or a mercapto group at the same time; and there is no case where R₅, R₇, and R₈ represent -NR₁₉R₂₀, -NR₂₅R₂₆, and -NR₂₇R₂₈ respectively at the same time,
in Formula (B), each of R₅ to R₈ may form a cyclic structure by being bonded to each other,
in Formula (C), R₉ represents either a hydrocarbon group which may have a substituent or -NR_{C1}R_{C2}; and each of R_{C1} and R_{C2} independently represents a hydrogen atom or a hydrocarbon group which may have a substituent,
in Formula (C), R₁₀ represents a hydrogen atom or a hydrocarbon group which may have a substituent,
in Formula (C), R₁₁ represents a hydrocarbon group which may have a substituent, -CR₃₃=NR₃₄, or -NR_{C3}R_{C4}; and each of R₃₃, R₃₄, R_{C3}, and R_{C4} independently represents a hydrogen atom or a hydrocarbon group which may have a substituent,
in Formula (C), each of R₉ to R₁₁ may form a cyclic structure by being bonded to each other,
in Formula (D), each of R₁₂ to R₁₅ independently represents a hydrogen atom or a hydrocarbon group which may have a substituent; there is no case where all of R₁₂ to R₁₅ represent a hydrogen atom at the same time; and each of R₁₂ to R₁₅ may form a cyclic structure by being bonded to each other, and
in Formula (E), each of R₁₆ to R₁₈ independently represents an alkyl group which may have a substituent; and each of R₁₆ to R₁₈ may form a cyclic structure by being bonded to each other.

2. The conductive film forming composition according to claim 1,
wherein the metal particles A are particles of a metal selected from the group consisting of Ag, Cu, Al, Ni, and Ta.

3. The conductive film forming composition according to claim 1 or 2,
wherein in Formula (I), A^{m-} is an anion selected from the group consisting of SO₄²⁻, R_{A2}SO₄⁻, R_{A3}SO₃⁻, PO₄³⁻, R_{A4}PO₄²⁻, (R_{A5})₂PO₄⁻, PO₃³⁻, R_{A6}PO₃²⁻, (R_{A7})₂PO₃⁻, [BF₄]⁻, [B(CN)₄]⁻, [B(C₆H₅)₄]⁻, CN⁻, OCN⁻, SCN⁻, [R_{A8}-COO]⁻, [(R_{A9}-SO₂)₂N]⁻, N(CN)₂⁻, and (R_{A11})₂NCS₂⁻, and
each of R_{A2} to R_{A9} and R_{A11} independently represents a hydrogen atom or a hydrocarbon group which may have a substituent.

4. The conductive film forming composition according to any one of claims 1 to 3,
wherein in the Formula (I), Cⁿ⁺ is a cation selected from the group consisting of the Formulae (A) to (C).

5. The conductive film forming composition according to any one of claims 1 to 4,
wherein in the Formula (I), A^{m-} is an anion selected from the group consisting of SO₄²⁻, R_{A2}SO₄⁻, and R_{A3}SO₃⁻, and
each of R_{A2} and R_{A3} independently represents a hydrogen atom or a hydrocarbon group which may have a substituent.

6. Use of the conductive film forming composition according to any one of claims 1 to 5 for forming a conductive film.

7. Use of the conductive film forming composition according to any one of claims 1 to 5 for forming electrodes which are comprised in an organic thin film transistor.

8. Use according to claim 7, wherein the organic thin film transistor is used for forming an electronic paper or a display device.

9. Use of the conductive film forming composition according to any one of claims 1 to 5 for forming a wiring which is comprised in a wiring board.

## Patentansprüche

1. Zusammensetzung zur Bildung eines leitenden Filmes, enthaltend:
Metallteilchen A und
eine Verbindung B, dargestellt durch die folgende Formel (I)
cCⁿ⁺aA^{m-} Formel (I)
worin in der Formel (I) Cⁿ⁺ ein n-valentes Kation ist, n eine ganze Zahl von 1 bis 6 ist, worin dann, wenn n 1 ist, Cⁿ⁺ ein Kation ist, ausgewählt aus der Gruppe, bestehend aus den folgenden Formeln (A) bis (E), und wenn n 2 bis 6 ist, Cⁿ⁺ ein Kation ist, das als Teilstruktur n Kationen, ausgewählt aus der Gruppe, bestehend aus den folgenden Formeln (A) bis (E), im gleichen Molekül enthält,
worin in der Formel (I) A^{m-} ein m-valentes Anion mit Ausnahme von Anionen, ausgewählt aus der Gruppe, bestehend aus Cl⁻, Br⁻, I⁻, PF₆⁻, R_{A1}CO₃⁻, R_{A10}NHCOO⁻, SbF₆⁻ und AsF₆⁻ ist, jedes von R_{A1} und R_{A10} unabhängig ein Wasserstoffatom oder eine Kohlenwasserstoffgruppe ist, die einen Substituenten haben kann, und m eine ganze Zahl von 1 bis 3 ist,
in der Formel (I) c eine ganze Zahl von 1 bis 3 ist, a eine ganze Zahl von 1 bis 6 ist und c, n, a und m die Beziehung c x n = a x m erfüllen, 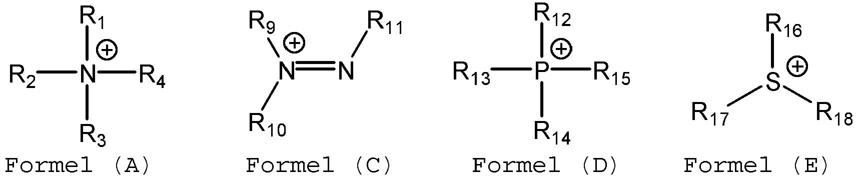
worin in der Formel (A) jedes von R₁ bis R₄ unabhängig ein Wasserstoffatom oder eine Kohlenwasserstoffgruppe sind, die einen Substituenten haben kann, keines von R₁ bis R₄ eine Hydroxyalkylgruppe ist, es keinen Fall gibt,
worin alle von R₁ bis R₄ ein Wasserstoffatom gleichzeitig sind, jedes von R₁ bis R₄ eine cyclische Struktur bilden kann, indem sie aneinander gebunden sind, und zumindest eines von R₁ bis R₄ eine aromatische Kohlenwasserstoffgruppe ist,
in der Formel (B) R₅ eine Kohlenwasserstoffgruppe, die einen Substituenten haben kann, -NR₁₉R₂₀, -N=CR₂₁R₂₂, -CR₂₃=NR₂₄ oder -CR_{B1}R_{B2}-NR_{B3}R_{B4} ist, worin jedes von R₁₉ bis R₂₄ und R_{B1} bis R_{B4} unabhängig ein Wasserstoffatom oder eine Kohlenwasserstoffgruppe ist, die einen Substituenten haben kann, und jedes von R₁₉ und R₂₀ eine cyclische Struktur bilden kann, indem sie aneinander gebunden sind,
in der Formel (B) R₆ ein Wasserstoffatom oder eine Kohlenwasserstoffgruppe, die einen Substituenten haben kann, ist,
in der Formel (B) R₇ ein Wasserstoffatom, Kohlenwasserstoffgruppe, die einen Substituenten haben kann, Alkoxygruppe, Alkylthiogruppe, Hydroxygruppe, Mercaptogruppe oder -NR₂₅R₂₆ ist und jedes von R₂₅ und R₂₆ unabhängig ein Wasserstoffatom oder eine Kohlenwasserstoffgruppe ist, die einen Substituenten haben kann, und die eine cyclische Struktur bilden können, indem sie aneinander gebunden sind,
in der Formel (B) R₈ ein Wasserstoffatom, Kohlenwasserstoffgruppe, die einen Substituenten haben kann, Alkoxygruppe, Alkylthiogruppe, Hydroxygruppe, Mercaptogruppe oder -NR₂₇R₂₈, -N=CR₂₉R₃₀,
oder -CR₃₁=NR₃₂ ist, jedes von R₂₇ bis R₃₂ unabhängig ein Wasserstoffatom oder eine Kohlenwasserstoffgruppe sind, die einen Substituenten haben kann, und R₂₇ und R₂₈ eine cyclische Struktur bilden kann, indem sie aneinander gebunden sind,
worin es keinen Fall gibt, bei dem beide von R₇ und R₈ eine Alkoxygruppe, Hydroxygruppe, Alkylthiogruppe oder Mercaptogruppe gleichzeitig bilden, und es keinen Fall gibt, worin R₅, R₇ und R₈ -NR₁₉R₂₀, -NR₂₅R₂₆, und -NR₂₇R₂₈ jeweils zur gleichen Zeit bilden,
in der Formel (B) jedes von R₅ bis R₈ eine cyclische Struktur bilden kann, indem sie aneinander gebunden sind,
in der Formel (C) R₈ entweder eine
Kohlenwasserstoffgruppe, die einen Substituenten haben kann, oder -NR_{C1}R_{C2} ist, und jedes von R_{C1} und R_{C2} unabhängig ein Wasserstoffatom oder eine Kohlenwasserstoffgruppe ist, die einen Substituenten haben kann,
in der Formel (C) R₁₀ ein Wasserstoffatom oder eine Kohlenwasserstoffgruppe, die einen Substituenten haben kann,
in der Formel (C) R₁₁ eine Kohlenwasserstoffgruppe, die einen Substituenten haben kann, oder -CR₃₃=NR₃₄ oder -NR_{C3}NR_{C4} ist, und jedes von R₃₃, R₃₄, R_{C3} und R_{C4} unabhängig ein Wasserstoffatom oder eine Kohlenwasserstoffgruppe ist, die einen Substituenten haben kann,
in der Formel (C) jedes von Rg und R₁₁ eine cyclische Struktur bilden kann, indem sie aneinander gebunden sind,
in der Formel (D) jedes von R₁₂ bis R₁₅ unabhängig ein Wasserstoffatom oder eine Kohlenwasserstoffgruppe ist, die einen Substituenten haben kann, es keinen Fall gibt, worin alle von R₁₂ bis R₁₅ ein Wasserstoffatom gleichzeitig sind, und jedes von R₁₂ bis R₁₅ eine cyclische Struktur bilden kann, indem sie aneinander gebunden sind, und
in der Formel (E) jedes von R₁₆ bis R₁₈ unabhängig eine Alkylgruppe ist, die einen Substituenten haben kann, und jedes von R₁₆ bis R₁₈ eine cyclische Struktur bilden kann, indem sie aneinander gebunden sind.

2. Zusammensetzung zur Bildung eines leitenden Films gemäß Anspruch 1, worin die Metallteilchen A Teilchen aus einem Metall sind, ausgewählt aus der Gruppe, bestehend aus Ag, Cu, Al, Ni und Ta.

3. Zusammensetzung zur Bildung eines leitenden Films gemäß Anspruch 1 oder 2, worin in der Formel (I) A^{m-} ein Anion ist, ausgewählt aus der Gruppe, bestehend aus SO₄²⁻, R_{A2}SO₄⁻, R_{A3}SO₃⁻ , PO₄³⁻, R_{A4}PO₄²⁻, (R_{A5}) ₂PO₄⁻, PO₃³⁻, R_{A6}PO₃²⁻, (R_{A7})₂PO₃⁻, [BF₄] ⁻, [B(CN)₄]⁻, [B(C₆H₅)₄]⁻, CN⁻, OCN⁻, SCN⁻, [R_{A8}-COO]⁻, [(R_{A9}-S_{O2})₂N]⁻, N(CN)₂⁻ und (R_{A11})₂NCS₂⁻ und
jedes von R_{A2} bis R_{A9} und R_{A11} unabhängig ein Wasserstoffatom oder eine Kohlenwasserstoffgruppe ist, die einen Substituenten haben kann.

4. Zusammensetzung zur Bildung eines leitenden Films gemäß einem der Ansprüche 1 bis 3, worin in der Formel (I) Cⁿ⁺ ein Kation ist, ausgewählt aus der Gruppe, bestehend aus den Formeln (A) bis (C).

5. Zusammensetzung zur Bildung eines leitenden Films gemäß einem der Ansprüche 1 bis 4, worin in der Formel (I) A^{m-} ein Anion ist, ausgewählt aus der Gruppe, bestehend aus SO₄²⁻, R_{A2}SO₄⁻ und R_{A3}SO₃⁻ und
jedes von R_{A2} und R_{A3} unabhängig ein Wasserstoffatom oder eine Kohlenwasserstoffgruppe ist, die einen Substituenten haben kann.

6. Verwendung der Zusammensetzung zur Bildung eines leitenden Films gemäß einem der Ansprüche 1 bis 5, zur Bildung eines leitenden Films.

7. Verwendung der Zusammensetzung zur Bildung eines leitenden Films gemäß einem der Ansprüche 1 bis 5, zur Bildung von Elektroden, die in einem organischen Dünnfilmtransistor enthalten sind.

8. Verwendung gemäß Anspruch 7, worin der organische Dünnfilmtransistor zur Bildung von elektronischem Papier oder einer Anzeigevorrichtung verwendet wird.

9. Verwendung der Zusammensetzung zur Bildung eines leitenden Films gemäß einem der Ansprüche 1 bis 5, zur Bildung eine Leitung, die in einer Leitungsplatte enthalten ist.

## Revendications

1. Composition de formation de film conducteur comprenant :
des particules métalliques A ; et
un composé B représenté par la formule (I) suivante,
cCⁿ⁺aA^{m-} Formule (I)
dans la formule (I), Cⁿ⁺ représente un cation n-valent ; n représente un entier de 1 à 6 ; dans un cas où n vaut 1, Cⁿ⁺ représente un cation choisi dans le groupe consistant en les formules (A) à (E) suivantes ; et dans un cas où n vaut 2 à 6, Cⁿ⁺ représente un cation présentant, en tant que structure partielle, n cations choisis dans le groupe consistant en les formules (A) à (E) suivantes dans la même molécule,
dans la formule (I), A^{m-} représente un anion m-valent excluant des anions choisis dans les groupes consistant en Cl⁻, Br⁻, l⁻, PF₆⁻, R_{A1}CO₃⁻, R_{A10}NHCOO⁻, SbF₆⁻ et AsF₆⁻ ; chacun de R_{A1} et R_{A10} représente indépendamment un atome d'hydrogène ou un groupe hydrocarboné qui peut présenter un substituant ; et m représente un entier de 1 à 3,
dans la formule (I), c représente un entier de 1 à 3 ; a représente un entier de 1 à 6 ; et c, n, a et m satisfont une expression relationnelle de c x n = a x m, 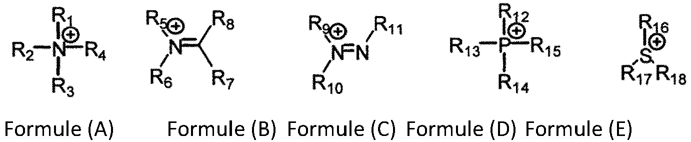
dans la formule (A), chacun de R₁ à R₄ représente indépendamment un atome d'hydrogène ou un groupe hydrocarboné qui peut présenter un substituant ; aucun de R₁ à R₄ n'est un groupe hydroxyalkyle ; il n'y a pas de cas où tous de R₁ à R₄ représentent un atome d'hydrogène en même temps ; chacun de R₁ à R₄ peut former une structure cyclique en étant lié les uns aux autres; et au moins l'un de R₁ à R₄ est un groupe hydrocarboné aromatique,
dans la formule (B), R₅ représente un groupe hydrocarboné qui peut présenter un substituant, -NR₁₉R₂₀, -N = CR₂₁R₂₂, -CR₂₃ = NR₂₄, ou -CR_{B1}R_{B2}-NR_{B3}R_{B4} ; chacun de R₁₉ à R₂₄ et R_{B1} à R_{B4} représente indépendamment un atome d'hydrogène ou un groupe hydrocarboné qui peut présenter un substituant ; et chacun de R₁₉ et R₂₀ peut former une structure cyclique en étant lié l'un à l'autre,
dans la formule (B), R₆ représente un atome d'hydrogène ou un groupe hydrocarboné qui peut présenter un substituant,
dans la formule (B), R₇ représente un atome d'hydrogène, un groupe hydrocarboné pouvant présenter un substituant, un groupe alkoxy, un groupe alkylthio, un groupe hydroxy, un groupe mercapto, ou -NR₂₅R₂₆; et chacun de R₂₅ et R₂₆ représente indépendamment un atome d'hydrogène ou un groupe hydrocarboné qui peut présenter un substituant, et peut former une structure cyclique en étant lié l'un à l'autre,
dans la formule (B), R₈ représente un atome d'hydrogène, un groupe hydrocarboné qui peut présenter un substituant, un groupe alkoxy, un groupe alkylthio, un groupe hydroxy, un groupe mercapto, -NR₂₇R₂₈, -N = CR₂₉R₃₀, ou -CR₃₁ = NR₃₂ ; chacun de R₂₇ à R₃₂ représente indépendamment un atome d'hydrogène ou un groupe hydrocarboné qui peut présenter un substituant ; et R₂₇ et R₂₈ peuvent former une structure cyclique en étant liés l'un à l'autre,
il n'y a pas de cas où à la fois R₇ et R₈ représentent un groupe alkoxy, un groupe hydroxy, un groupe alkylthio ou un groupe mercapto en même temps ; et il n'y a pas de cas où R₅, R₇ et R₈ représentent respectivement -NR₁₉R₂₀, -NR₂₅R₂₆ et -NR₂₇R₂₈ en même temps,
dans la formule (B), chacun de R₅ à R₈ peut former une structure cyclique en étant lié les uns aux autres,
dans la formule (C), R₉ représente soit un groupe hydrocarboné qui peut présenter un substituant soit -NR_{C1}R_{C2}; et chacun de R_{C1} et R_{C2} représente indépendamment un atome d'hydrogène ou un groupe hydrocarboné qui peut présenter un substituant,
dans la formule (C), R₁₀ représente un atome d'hydrogène ou un groupe hydrocarboné qui peut présenter un substituant,
dans la formule (C), R₁₁ représente un groupe hydrocarboné qui peut présenter un substituant, -CR₃₃ = NR₃₄, ou -NR_{C3}R_{C4} ; et chacun de R₃₃, R₃₄, R_{C3} et R_{C4} représente indépendamment un atome d'hydrogène ou un groupe hydrocarboné qui peut présenter un substituant,
dans la formule (C), chacun de R₉ à R₁₁ peut former une structure cyclique en étant lié les uns aux autres,
dans la formule (D), chacun de R₁₂ à R₁₅ représente indépendamment un atome d'hydrogène ou un groupe hydrocarboné qui peut présenter un substituant ; il n'y a pas de cas où tous de R₁₂ à R₁₅ représentent un atome d'hydrogène en même temps ; et chacun de R₁₂ à R₁₅ peut former une structure cyclique en étant lié les uns aux autres, et
dans la formule (E), chacun de R₁₆ à R₁₈ représente indépendamment un groupe alkyle qui peut présenter un substituant ; et chacun de R₁₆ à R₁₈ peut former une structure cyclique en étant lié les uns aux autres.

2. Composition de formation de film conducteur selon la revendication 1,
dans laquelle les particules métalliques A sont des particules d'un métal choisi dans le groupe consistant en Ag, Cu, Al, Ni et Ta.

3. Composition de formation de film conducteur selon la revendication 1 ou 2,
dans laquelle dans la formule (I), A^{m-} est un anion choisi dans le groupe consistant en SO₄²⁻, R_{A2}S0₄', R_{A3}SO₃⁻, PO₄³⁻, R_{A4}PO₄²⁻, (R_{A5})₂PO₄⁻, PO₃³⁻, R_{A6}PO₃²⁻, (R_{A7})₂PO₃⁻, [BF₄]⁻, [B(CN)₄]⁻, [B(C₆H₅)₄]⁻, CN⁻, OCN⁻, SCN⁻, [R_{A8}-COO]⁻, [(R_{A9}-SO₂)₂N]⁻, N(CN)₂⁻ et (R_{A11})₂NCS₂⁻, et
chacun de R_{A2} à R_{A9} et R_{A11} représente indépendamment un atome d'hydrogène ou un groupe hydrocarboné qui peut présenter un substituant.

4. Composition de formation de film conducteur selon l'une quelconque des revendications 1 à 3,
dans laquelle dans la formule (I), Cⁿ⁺ est un cation choisi dans le groupe consistant en les formules (A) à (C).

5. Composition de formation de film conducteur selon l'une quelconque des revendications 1 à 4,
dans laquelle dans la formule (I), A^{m-} est un anion choisi dans le groupe consistant en SO₄²⁻, R_{A2}SO₄⁻ et R_{A3}SO₃⁻, et
chacun de R_{A2} et R_{A3} représente indépendamment un atome d'hydrogène ou un groupe hydrocarboné qui peut présenter un substituant.

6. Utilisation de la composition de formation de film conducteur selon l'une quelconque des revendications 1 à 5 pour former un film conducteur.

7. Utilisation de la composition de formation de film conducteur selon l'une quelconque des revendications 1 à 5 pour former des électrodes qui sont comprises dans un transistor à couches minces organiques.

8. Utilisation selon la revendication 7, dans laquelle le transistor à couches minces organiques est utilisé pour former un papier électronique ou un dispositif d'affichage.

9. Utilisation de la composition de formation de film conducteur selon l'une quelconque des revendications 1 à 5 pour former un câblage qui est compris dans une carte de câblage.
